# EUROPEAN PATENT APPLICATION

(11) **EP 4 358 121 A1**
(43) Date of publication of application: **24.04.2024**
(21) Application number: 22202269.1
(22) Date of filing: 18.10.2022
(51) Int. Cl.: H01L 21/67, H01L 21/683

(54) **METHOD AND DEVICE FOR DEPOSITING COMPONENTS ON A TARGET SURFACE OF A TARGET AS WELL AS DONOR PLATE FOR USE THEREWITH**

(71) Applicant: Nederlandse Organisatie voor toegepast-natuurwetenschappelijk Onderzoek TNO, 2595 DA 's-Gravenhage (NL)
(72) Inventor: HENDRIKS, Rob Jacob, 2595 DA 's-Gravenhage (NL); KOLDEWEIJ, Robin Bernardus Johannes, 2595 DA 's-Gravenhage (NL)
(74) Representative: V.O.

(57) **Abstract**

A deposition device (1) is disclosed herein for depositing components (Ca, Cb,..) on a target surface (TS) of a target (T), the deposition device comprises a donor plate (3), at least one heater element (33), a power supply (6), a target manipulation device and a controller (5) configured for controlling the power supply (6) and the target manipulation device (2;21, 22). The controller causes the power supply (6) to supply at least a first pulse (Pulse 1) of electric power to the at least one heater element (33) in a zone (32) to heat the donor plate surface (31s) in at least a first subzone (32a) of that zone to a surface temperature exceeding a threshold temperature of an adhesive specimen (7a) in said first subzone (32a). Subsequent to a change of a lateral position of the target (T) relative to the donor plate (3), the controller causes the power supply (6) to supply at least a second pulse (Pulse 2) of electric power to the heater element to heat the donor plate surface (31s) in at least a second subzone (32b) to a surface temperature exceeding a threshold temperature of the adhesive specimen (7b) in said second subzone (32b). Therewith components within a zone sharing a same heater element can be transferred independently from each other.

## Description

The present invention pertains to a method for depositing components on a target surface of a target.

The present invention further pertains to a device for depositing components on a target surface of a target.

The present invention still further pertains to a donor plate for use with the device and/or method.

### BACKGROUND

US2020168498 discloses a method of transferring multiple discrete components from a first substrate to a second substrate. The method includes illuminating multiple regions on a top surface of a dynamic release layer that adheres the multiple discrete components to the first substrate. The illuminating induces a plastic deformation in each of the irradiated regions of the dynamic release layer. The plastic deformation causes at least some of the discrete components to be concurrently released from the first substrate.

It is a disadvantage of the known approach that the resolution with which the transfer of the components can be independently controlled is bounded by the resolution with which the dynamic release layer can be heated.

Accordingly, there is a need to provide for an improved approach that enables a controllable transfer of components at a resolution higher than that determined by the resolution with which heat is applied.

### SUMMARY

In accordance with a first aspect of the present disclosure, a novel deposition device is provided that is improved in that it enables a controlled transfer of components from a donor plate to a target with a resolution that is higher than that determined by the resolution with which heat is applied to the donor plate.

In accordance with a second aspect of the present disclosure, a novel deposition method is provided that is improved in that it enables a controlled transfer of components from a donor plate to a target with a resolution that is higher than that determined by the resolution with which heat is applied to the donor plate.

Embodiments of the improved deposition device comprise a donor plate, at least one heater element, a power supply, a target manipulation device and a controller.

The at least one heater element is provided to heat a donor plate surface of the donor plate in at least one zone. In one example, the heater element is a flash light or a laser, so as to heat the at least one zone by photon radiation directed to that zone. In another example, the heater element is a resistive heater layer arranged below the donor plate surface of the donor plate in at least one zone.

The donor plate surface is configured for temporarily adhering thereto respective components with a respective adhesive specimen in respective subzones of the at least one zone. An adhesive specimen adhering a component in a subzone evaporates if a temperature of the donor surface in the respective subzone exceeds a threshold temperature of the adhesive specimen.

The power supply is configured for controllably supplying a pulse of electric power to the at least one heater element to heat the donor plate surface in the at least one zone.

The target manipulation device is configured for laterally positioning the target relative to the donor plate, while holding the target with its target surface facing the donor plate surface. In one example, the target manipulation device laterally positions a target carrier that carries the target while holding the donor plate in a fixed position. In another example, the target manipulation device laterally positions the donor plate with the target in a fixed lateral position. In again another example, the target manipulation device laterally positions the donor plate as well as the target.

The controller is configured for controlling the power supply and the target manipulation device. The controller has a first operational state wherein it causes the power supply to supply at least a first pulse of electric power to the at least one heater element to heat the donor plate surface in the at least a first subzone to a surface temperature exceeding a threshold temperature of the adhesive specimen in said first subzone. The controller has a second operational state wherein it causes the target manipulation device to change a lateral position of the target relative to the donor plate. The controller further has a a third operational state wherein it causes the power supply to supply at least a second pulse of electric power to the at least one heater element to heat the donor plate surface in the at least a second subzone to a surface temperature exceeding a threshold temperature of the adhesive specimen in said second subzone.

Whereas the heater element in both the first and the third operational state heats a same zone, this does not cause a simultaneous transfer of the components in the various subzones of that zone.

Typically the at least one zone is partitioned in a number of subzones that is substantially larger than 2, e.g. 16. In that case the controller is configured to supply a corresponding number of pulses, such that in each pulse the surface temperature exceeds a threshold temperature of a respective adhesive specimen adhering a respective component in a respective subzone and therewith inducing a vapor pressure by evaporation of the respective adhesive specimen that causes a transfer of the respective component.

The second pulse may have a duration longer than that of the first pulse and/or have an electric power greater than that of the first pulse. Analogously, if a zone comprises more than two subzones then each next pulse again has a longer duration and/or has a greater electric power.

The donor plate may comprise a plurality of zones that each may be partitioned in subzones. In an embodiment each zone has a proper resistive heater element. In another embodiment wherein photon radiation is used as the source of heat, a single photon radiation source, e.g. a laser is used that is selectively directed to the various zones.

In an embodiment of the deposition device the donor plate comprises in the at least one second subzone a thermal buffer layer between the at least one heater element and the donor plate surface. The thermal buffer layer in the second subzone reduces a heat flux from the at least one heater element to the donor surface in the second subzone so that the surface temperature as a function of time in the second subzone lags with respect to the surface temperature as a function of time in the first subzone. In this embodiment the same adhesive can be used for the respective adhesive specimen that adhering the respective components in their respective subzone. In the first operational state the surface temperature in the first subzone exceeds the threshold temperature of the adhesive, so that a transfer of the component in the first subzone occurs. However, the surface temperature in the second subzone remains below the threshold temperature so that the component in that subzone remains adhered. In the second operational state the pulse with the longer duration and/or greater electric power causes also the surface temperature in the second subzone to exceed the threshold temperature of the adhesive, so that a transfer of the component in the second subzone occurs. In the first subzone a thermal buffer layer may be absent or have a thickness less than that of the thermal buffer layer in the second subzone. Alternatively or additionally, it is possible to use mutually different materials for thermal buffer layers in respective subzones to control conduction of heat from the heater element to the donor plate surface.

In another embodiment the adhesive specimen adhering the component in the second subzone of the donor surface has a threshold temperature higher than that of the adhesive specimen adhering the component in the first subzone of the donor surface. In this embodiment a pattern thermal buffer layer is not required.

In the first operational state of the controller the surface temperature in the first subzone exceeds the threshold temperature of the adhesive of the adhesive specimen present therein, so that a transfer of the component in the first subzone occurs. However, the surface temperature in the second subzone remains below the higher threshold temperature of the adhesive of the specimen in the second subzone, so that the component in that subzone remains adhered. In the second operational state the pulse with the longer duration and/or greater electric power causes also the surface temperature in the second subzone to exceed also the higher threshold temperature of the adhesive used for that second subzone, so that a transfer of the component in the second subzone occurs.

It is noted that aspects of the latter two embodiments can be combined. I.e. a patterned thermal buffer layer may be provided within a zone, and different subzones may have different adhesives.

One way to modify the threshold temperature of an adhesive is the use of photo acid generators like TAG or PAG added thereto. Before placing the components on the donor plate, a coating of an adhesive material with one or more of these additives is exposed under mutually different curing conditions, for example by exposing with mutually different intensity and/or duration of photon radiation to control the decomposition temperature per subzone in a zone. Other additives can also be used, but they may be difficult to pattern. Examples of tuning polymer degradation is described by Phillips et al. in "Polymer Degradation and Stability" in Science Direct, Volume 125, March 2016, Pages 129-139.

Embodiments of the improved method for depositing components on a target surface of a target comprise the following steps.

Providing a donor plate with at least one heater element to heat a donor plate surface of the donor plate in at least one zone of the donor plate.

Adhering respective components with respective adhesive specimen to the donor surface in respective subzones of the at least one zone wherein an adhesive specimen adhering a component in a respective subzone evaporates if a temperature of the donor plate surface in the respective subzone exceeds a threshold temperature of said adhesive specimen.

Positioning the target with its target surface facing the donor plate surface of the donor plate.

Supplying at least a first pulse of electric power to the at least one heater element to heat the donor surface wherein a temperature of the donor plate surface in at least a first one of the subzones assumes a value that is at least the threshold temperature of the adhesive species adhering a first component in said first one of the subzones to eject the first component and wherein a temperature of the donor surface in at least a second one of the subzones assumes a value that does not exceed the threshold temperature of the adhesive species adhering the component in said second one of the subzones.

Laterally translating the target relative to the donor plate.

Supplying at least a second pulse of electric power to the at least one heater element to heat the donor surface, wherein a temperature of the donor surface in the second one of the subzones assumes a value that is at least the threshold temperature of the adhesive species adhering the component in said second one of the subzones therewith ejecting the component in the second subzone towards the target.

In an embodiment of the method the donor plate is provided with a thermal buffer layer between the at least one heater element and the donor plate surface.

In an alternative embodiment or in a combination with the preceding embodiment the component in the second subzone of the donor surface is adhered with an adhesive specimen that has a threshold temperature higher than that of the adhesive specimen adhering the component in the first subzone of the donor surface.

Adhesive specimen provided with a thickness in a range of 0.1 µm to 10 µm additionally serves as a thermal insulation to achieve that components that remain on the donor plate remain relatively cool. Typically the thickness is selected from a range of 1 µm to 5 µm.

In some embodiments a temporary carrier is used to adhere the components to the donor plate prior to transferring them to the target. Therein the temporary carrier with said components adhered thereto is pressed against the donor plate surface provided with the adhesive material. Subsequently, the temporary carrier is removed, to leave the components adhered to the adhesive on surface of the donor plate. In an example thereof the components are relatively weakly adhered to the temporary carrier, so that a relatively strong adhesive force exerted by the adhesive material on the donor plate achieves that the components remain on the donor plate. In another example the temporary carrier is a photo-sensitive-release tape. After the tape with the components is pressed to the adhesive on the donor plate an adhesion of the components to the photo-sensitive-release tape is reduced by irradiating the photo-sensitive-release tape with photon radiation. In this case it is not necessary that a weak adhesive is used for the temporary carrier.

In an embodiment of the improved method the adhesive material provided on the surface of donor plate is a positive photoresist. Subsequent to adhering the respective components, UV-radiation is directed to a side of the donor plate having the components adhered at its surface to expose portions of the positive resist present between said components to said UV-radiation, and wherein subsequently the exposed portions of the positive resist are removed. Therewith it is avoided that shear forces may occur between mutually neighboring components when one thereof is transferred.

In a still further embodiment, which may be combined with any of the preceding embodiments the donor plate surface is provided in mutually different subzones with spacer pillars of mutually different height. An adhesive specimen is provided between the pillars in the subzones at a height exceeding that of said pillars. Then the respective components are pressed against the pillars in the respective zones, therewith bringing the component in contact with the adhesive specimen to adhere the components to the donor plate surface. It is preferred that a volume of of the adhesive specimen in each subzone is less than a volume defined between the pillars in each subzone. Therewith it is avoided that the adhesive specimen contact the pillars when the components are pressed against the pillars. This avoids that shear forces can occur during component transfer to the target. In one example of the embodiment providing adhesive specimen comprises uniformly depositing an adhesive or a precursor thereof on the donor plate surface with the spacer pillars to a height exceeding a height of the highest spacer pillars. The pillar height controls a heat sinking effect into a component present thereon. The lower the pillar height, the stronger the heat sinking effect. Therewith it is achieved that upon heating a zone, the temperature of the surface in a subzone between the lower pillars remains below a temperature of a subzone between the higher pillars. This renders it possible to exceed a single predetermined threshold temperature in successive subzones having successively higher pillars by generating heating pulses with successively increasing duration and/or power. In an example of this embodiment the adhesive used is a photoresist comprising a photoacid generator. The threshold temperature of the adhesive can be modified to a different value in mutually different subzones by activating the photoacid generator to a mutually different extent as determined by a duration or intensity of irradiation with photo radiation (e.g. UV-radiation). It is in this case not necessary that the pillars have a mutually different height. However, the two measures can be combined in that on the one hand a temperature distribution within a zone is determined by the height of the pillars and in addition adhesive specimen in mutually different subzones are provided a respective threshold temperature by activating the photoacid generator to a mutually different extent therein. In case the adhesive material is a positive photoresist, a respective portion thereof in each subzone is selectively cured, and the uncured material is removed. The volume of the portion to be cured in each subzone should be smaller than the volume enclosed by the pillars of the subzone. This is to avoid that the remaining portion contacts the pillars when it is compressed by the component supported by the pillars. As noted above, the photoresist in each subzone may have a mutually different threshold temperature as a result of being activated to a mutually different extent.

It is noted that this process is also possible, yet more difficult, with negative photoresist. In that case, the adhesive for the components would need to be cross-linked in order to remove the excess uncured material, which makes it difficult to apply different curing degrees per adhesive patch. Also, curing of negative resists typically makes it difficult to melt/reflow the resist.

The present disclosure further provides an improved donor plate for use in the deposition device or in the deposition method. The improved donor plate comprises
at least one heater element to heat a donor plate surface in at least one zone, the donor plate surface being configured for temporarily adhering thereto respective components with a respective adhesive specimen in respective subzones of the at least one zone wherein an adhesive specimen adhering a component in a respective subzone evaporates if a temperature of the donor surface in the respective subzone exceeds a threshold temperature of said adhesive specimen;
wherein the donor plate comprises in the at least one second subzone a thermal buffer layer between the at least one heater element and the donor plate surface.

### BRIEF DESCRIPTION OF THE DRAWINGS

These and other aspects of the present disclosure are described in more detail with respect to the drawings. Therein:
FIGs. 1 and 2 schematically shows an embodiment of an improved deposition device for depositing components on a target surface of a target T;
FIG. 2 shows further details of a component thereof; Therein the upper part of

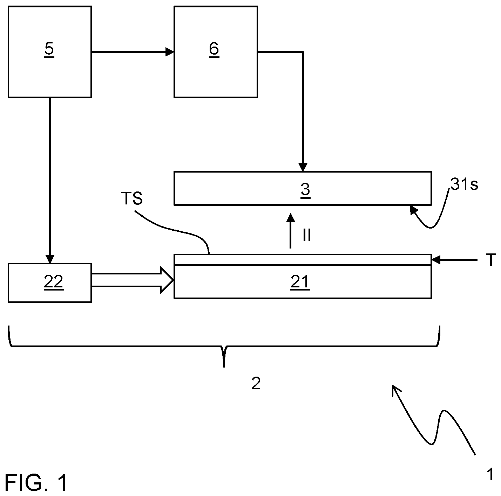

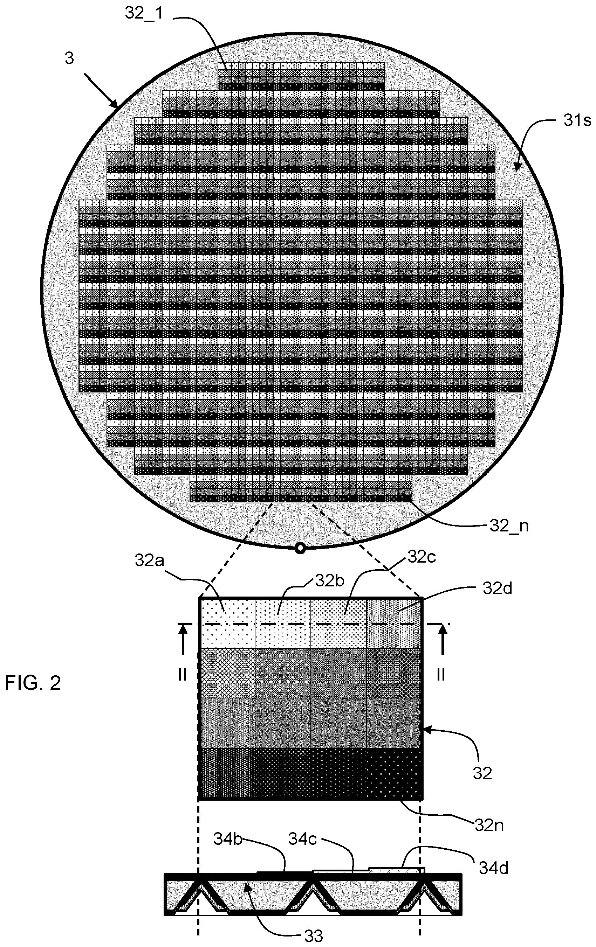

FIG. 2 shows a top view according to II in FIG. 1; The middle part of FIG. 2 shows one zone thereof in more detail; The lower part of FIG. 2 shows a cross-section through this zone according to II-II in the middle part of FIG. 2;

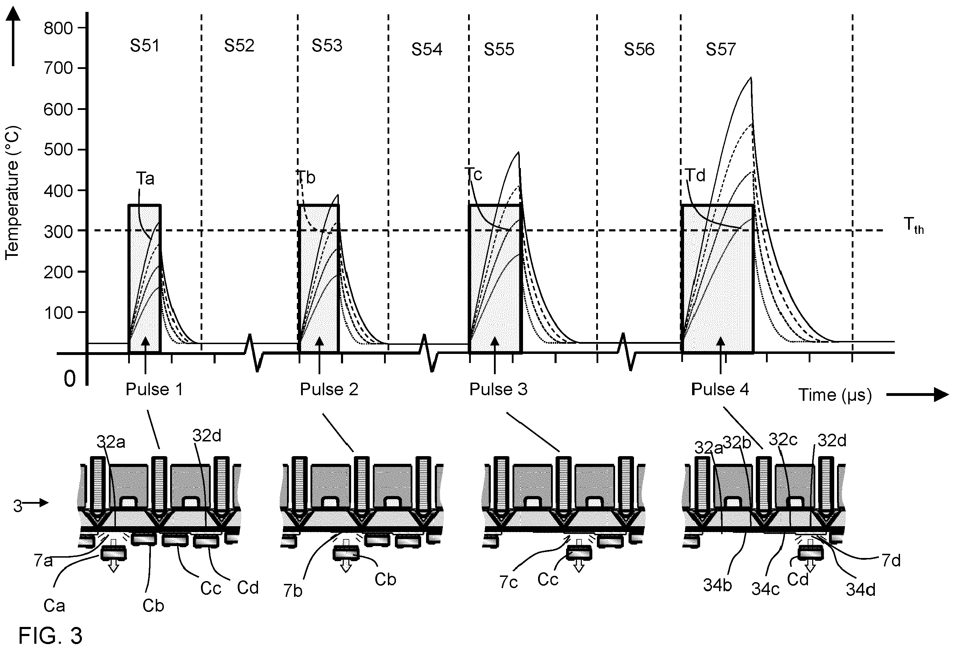

FIG. 3 shows aspects of an operation of the improved deposition device; Control aspects are schematically illustrated in the upper part of FIG. 3; The lower part of FIG. 3 shows corresponding physical states;

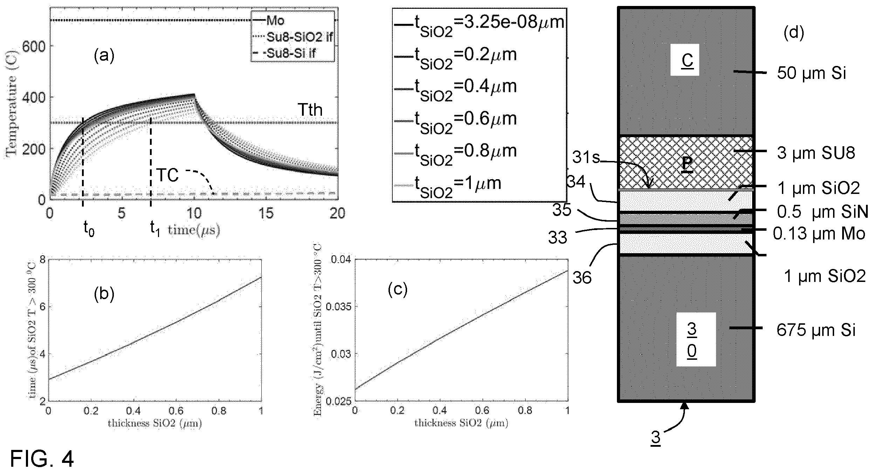

FIG. 4(a) to FIG. 4(d) shows aspects of a simulation of an embodiment of the improved method. FIG. 4(d) shows physical aspects of a model used for the simulation; FIG. 4(a) shows simulated temperature curves as a function of time;
FIG. 4(b) shows the required pulse time to achieve a predetermined surface temperature as a function of a physical dimension of a component;
FIG. 4(c) shows the required fluence as a function of said physical dimension to achieve that the predetermined surface temperature;

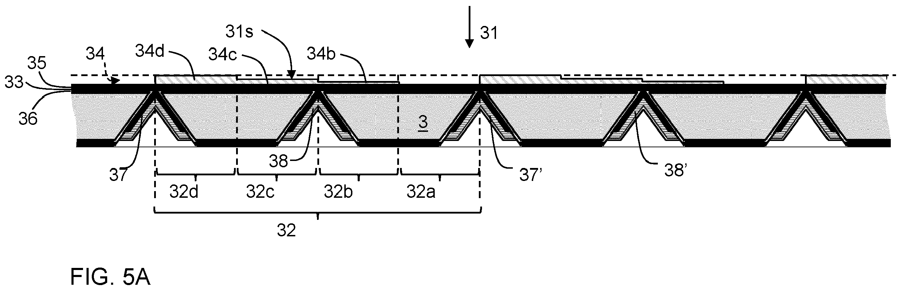

FIG. 5A to 5I show aspects of a first embodiment of the method in more detail;

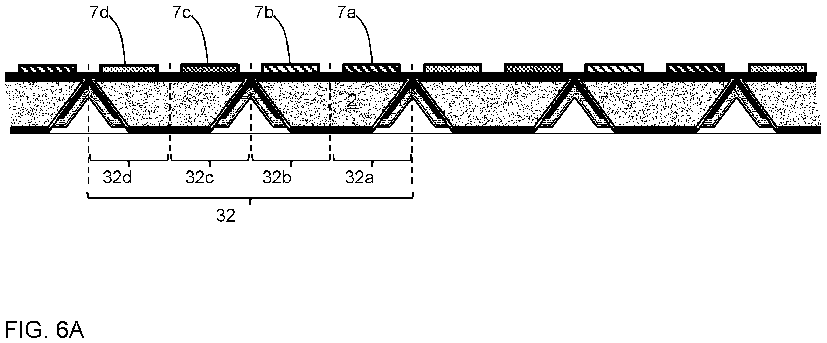

FIG. 6A to 6C show aspects of another embodiment;

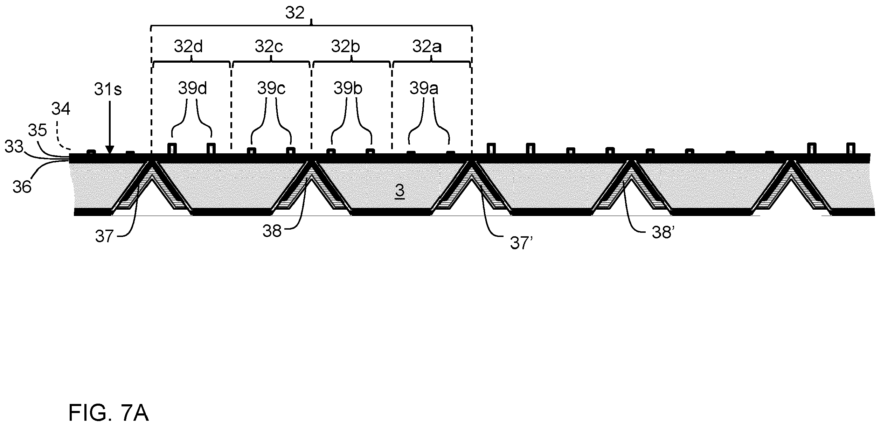

FIG. 7A - 7D show a still further embodiment,

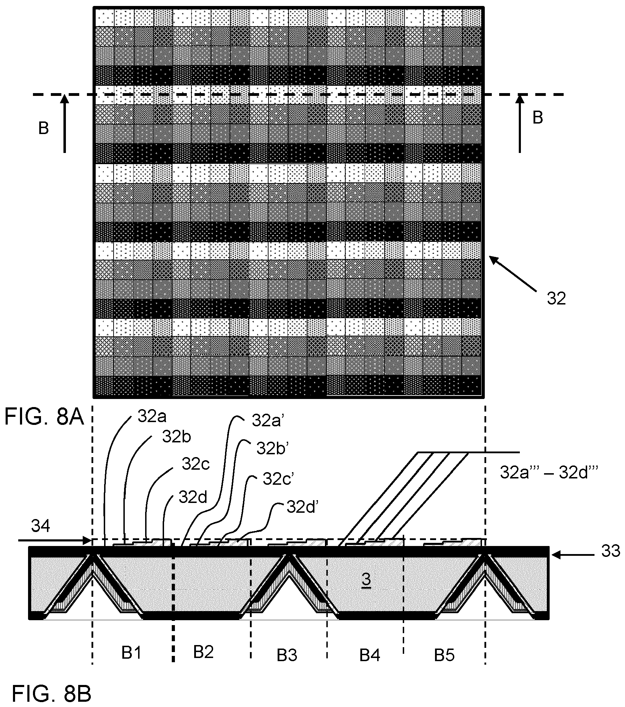

FIG. 8A and 8B show a component of a further embodiment of the deposition device

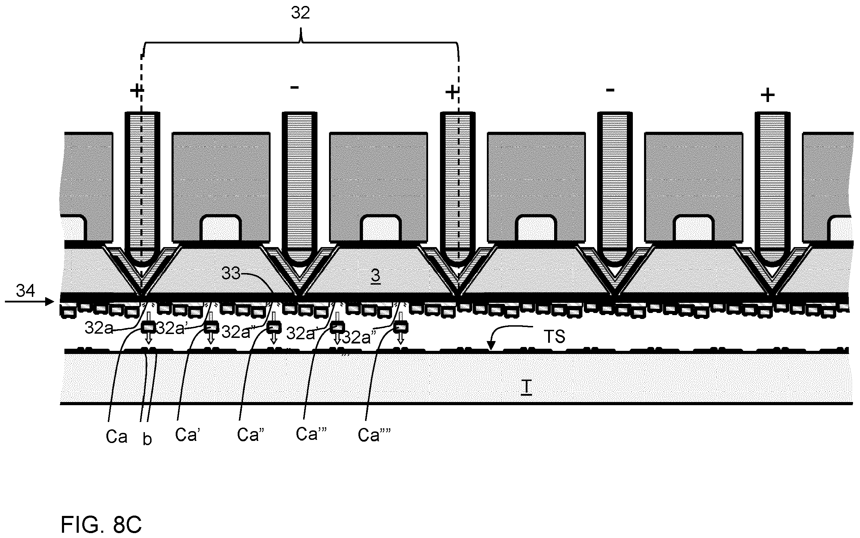

FIG. 8C show an operation performed by said further embodiment,

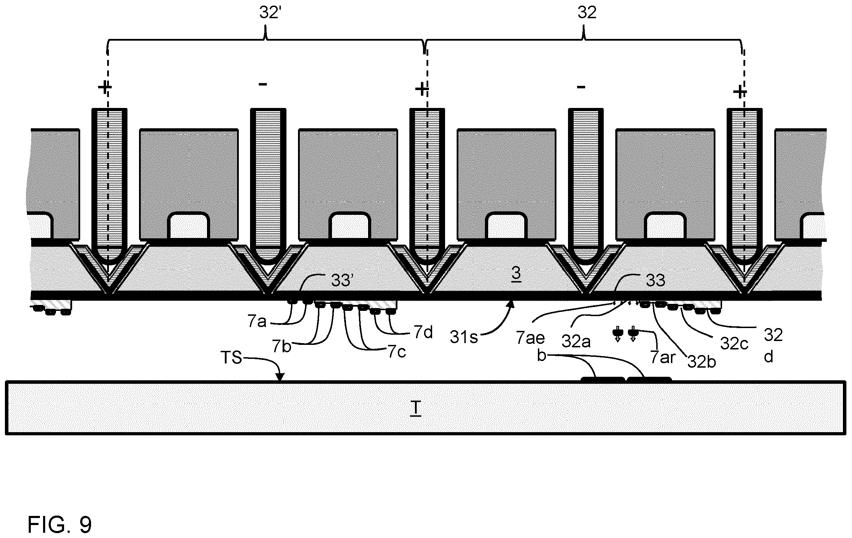

FIG. 9 shows a further application of an embodiment of the deposition device.

### DETAILED DESCRIPTION OF EMBODIMENTS

Like reference symbols in the various drawings indicate like elements unless otherwise indicated.

FIGs. 1 and 2 schematically show an embodiment of an improved deposition device 1 for depositing components Ca, Cb,.. on a target surface TS of a target T. As shown in FIG. 1, the deposition device comprises a donor plate 3 with a donor plate surface 31s, a power supply 6, a target manipulation device 2; 21, 22 and a controller 5 configured for controlling the power supply 6 and the target manipulation device 2.

The upper part of FIG. 2 shows the donor plate surface 31s in a top view according to II in FIG. 1. The middle part of FIG. 2 shows one zone 32 of the donor plate 3. The lower part of FIG. 2 shows a cross-section through this zone according to II-II in the middle part of FIG. 2.

The power supply 6 is configured for controllably supplying a pulse of electric power to a heater element 33 to heat the donor plate surface 31s in the zone 32. As shown in the upper part of FIG. 2, the donor plate 3 comprises a plurality of zones 32_1,...,32_n, one of which is the zone 32 depicted in the middle part and the lower part of FIG. 2, also denoted as the at least one zone.

The target manipulation device 2; 21, 22 as shown in FIG. 1 is configured for laterally positioning the target T relative to the donor plate 3, while holding the target T with its target surface TS facing the donor plate surface 31s

The controller 5 is configured for controlling the power supply 6 and the target manipulation device 2; 21, 22.

The donor plate surface 31s is configured for temporarily adhering thereto respective components with a respective adhesive specimen in respective subzones of the at least one zone 32. An adhesive specimen that is provided to adhere a component in a respective subzone is characterized by a threshold temperature. The adhesive specimen in a subzone evaporates if its temperature exceeds that threshold temperature.

The controller 5 is configured to assume successive operational states, at least comprising a first operational state, a second operational state and a third operational state. The operation of the controller 5 is schematically illustrated in the upper part of FIG. 3. The lower part of FIG. 3 shows corresponding states of the donor plate.

In the first operational state S51 the controller 5 causes the power supply 6 to supply at least a first pulse, Pulse 1, of electric power to the heater element 33 to heat the donor plate surface 31s in the at least a first subzone 32a to a surface temperature Ta exceeding a threshold temperature Tth of the adhesive specimen 7a in said first subzone 32a. As a result the adhesive specimen 7a or a portion thereof evaporates and the resulting vapor pressure causes a transfer of the component Ca towards the target surface. Also the remainder of the zone 32 is heated. However, as shown in the lower part of FIG. 2 and in the lower part of FIG. 3, subzone 32a is the only subzone of zone 32, wherein a thermal buffer layer is absent. The other subzones 32b, 32c, 32d,... all have a thermal buffer layer 34b, 34c, 34d, ...Furthermore, a thickness of the thermal buffer layer in the other subzones is mutually different. For example the thickness of the thermal buffer layer 34c is greater than that of the thermal buffer layer 34b, and the thickness of the thermal buffer layer 34d is greater than that of the thermal buffer layer 34c. As a result, the temperature in the other subzones remains below the threshold temperature of the adhesive specimen that adhere the components therein.

In a second operational state S52 the controller causes the target manipulation device 2 to change a lateral position of the target T relative to the donor plate 3.

Then in a third operational state S53 the controller causes the power supply 6 to supply at least a second pulse, Pulse 2, of electric power to the heater element to heat the donor plate surface 31s in the subzone 32b to a surface temperature that exceeds a threshold temperature of the adhesive specimen 7b in the second subzone 32b. As shown in the upper part of FIG. 3, the duration of the second pulse, Pulse 2, is longer than that of the first pulse, Pulse 1, so that now the surface temperature Tb in the second subzone 32b exceeds the threshold temperature Tth and the component Cb is transferred to the target. Due to the fact that the components Ca and Cb are transferred at mutually different points in time, and that the lateral position of the target T relative to the donor plate 3 is changed during the second operational state S52, the components Ca, Cb can have a relative position to each other on the target that is independent of their relative position on the donor plate. Likewise the components Cc and Cd can be deposited on arbitrary selected positions on the target, by subsequently supply a third pulse, Pulse 3 in operational state S55, and a fourth pulse, Pulse 4 in operational state S57 wherein each subsequent pulse as a longer duration than the previous one and by laterally moving the target T relative to the donor plate 3 between subsequent pulses in operational states S54 and S56. This can be extended to an independent transfer of a larger number of components with respective pulses of subsequently increasing pulse duration and/or pulse power if the zone is provided with a corresponding number of subzones with buffer layers of mutually different thicknesses. In the example shown in the middle part of FIG. 2, the zone 32 comprises 16 subzones with buffer layers of mutually different thicknesses. The thickness of the buffer layers in the subzones is schematically indicated by the shading thereof. A darker shading indicates a thicker buffer layer. It is noted that the spatial thickness distribution may be provided in another pattern than the one shown in FIG. 2, provided that the subzones within a zone have buffer layers of mutually different thicknesses. The thicknesses of the thermal buffer layer are for example selected from a range of 0 µm to 2 µm. That is, the thickness of the thermal buffer layer in the subzone with the component that has to be deposited first may have a value of 0 µm and the thickness of the thermal buffer layer in the subzone with the component that has to be deposited last may have a value of 2 µm. The thermal buffer is for example of a ceramic material such as SiO2. By providing respective subzones with respective thermal buffer layers with respective mutually different thicknesses in this range, respective mutually different heating delays can be achieved that are most suitable for practical purposes. It may alternatively or additionally be contemplated to use buffer layers with a mutually different composition in different subzones. However, also for practical purposes it is preferred to use buffer layers with mutually different thicknesses.

FIG. 4(a) to FIG. 4(d) shows aspects of a simulation of the method. As shown in FIG. 4(d) therein the donor plate 3 is modeled as comprising a stack built on a silicon wafer 30 having a thickness of 675 µm.The stack comprises in the order named, a thermal and electrical insulating layer 36 having a thickness of 1 µm, a resistive heater layer 33 being formed of Mo and having a thickness of 0.13 µm, an electrically insulating layer 35 of SiN, having thickness of 0.5 µm and a thermal buffer layer 34 of SiO2. The effect of the thickness of the thermal buffer layer on the heat flux in the donor surface is investigated. In these simulations the thickness of the thermal buffer layer 34 is varied in the range of 0 to 1 µm.

The model used for the simulations further comprises that a component C is adhered to the surface 31s of the donor plate 3 with an adhesive serving as the propulsion agent P. The modeled adhesive layer P has a thickness of 3 µm. The modeled properties of the adhesive are a heat conduction coefficient λ = 0.2 W/mK, a density ρ = 1200 kg/m3, and a heat capacity C = 1500 J/kgK. These are typical values for a photoresist such as SU-8 and other photoresist materials. and the modeled component C has a thickness of 50 µm.

FIG. 4(a) shows curves indicating the simulated temperature at the interface 31s between the adhesive P and the thermal buffer layer 34 as a function of time for the surface 31s of the donor plate 3 dependent on the thickness of the thermal buffer layer 34 when a heat flux of 75 kW/cm2 is generated in the heater layer 33 during an interval of 10 µs. It can be seen in FIG. 4(a) that the point in time t1 at which the surface 31s reaches the threshold temperature Tth in the presence of a 1 µm thick SiO2 layer 34 is about 4 µs later than the point in time t0 in case a thermal buffer layer is absent. Therewith it can be achieved that the surface 31s can be heated to the threshold temperature Tth while avoiding that the surface 31s in other subsections having a thermal buffer layer reach the threshold temperature Tth by timely interrupting the heating pulse. More generally, it can be achieved that the temperature of the surface can be heated to the threshold temperature in subsections having a thermal buffer layer less than predetermined thickness or no thermal buffer layer at all and it can be a avoided that a temperature in subsections having a thermal buffer layer with a thickness larger than the predetermined thickness reach the threshold temperature by timely interrupting the heating pulse.

FIG. 4(a) also shows the simulated temperature curve for the resistive heater layer 33. It was found that the resistive heater layer 33 does not exceed a temperature of around 600C.

The simulations further show, see the line TC, that the component, C here modeled as a silicon chip with a thickness of 50 µm does hardly heat up at all. This is achieved with the adhesive layer P, which has a low thermal conductivity. When using spacer structures, as shown in FIG. 7A - 7D, in the order of 1 µm and smaller, the heat sinking of the component will start to affect the temperature profile at the interface 31s of the adhesive P and the thermal buffer layer 34.

FIG. 4(b) shows the required pulse time to achieve that the temperature of the surface 31s of the donor plate 3 exceeds a threshold temperature Tth of 300 °C dependent on the thickness of the thermal buffer layer 34.

As the variation in fluence and heat flux is typically +/- 1% or better, threshold based transfer is possible when using a variable thickness of the thermal buffer layer 34 in the range of 0 to 2 µm.

FIG. 4(c) shows the required fluence to achieve that the temperature of the surface 31s of the donor plate 3 exceeds a threshold temperature Tth of 300 °C dependent on the thickness of the thermal buffer layer 34.

As can be seen in FIG. 4(b) and 4(c) the curves slightly deviate from each other as the simulations account for temperature dependent material properties. This includes the thermal conductivity of the silicon, and the change in resistance (positive temperature coefficient of resistance) of the molybdenum.

As noted above, the simulations are performed with a simulated heat flux of 75 kW/cm2. In order to reduce the time involved in performing the method a higher heat flux can be used instead. For example in case the heat flux induced by the resistive heater layer 33 is set to 150 kW/cm2, the release time, i.e. the time to reach the threshold temperature Tth at the surface respectively is about 1 µs and about 3 µs in the absence of a thermal buffer layer and in the presence of a 1 µm SiO2 thermal buffer layer 34. Despite the larger value of the heat flux, the total amount of energy that is required to reach the threshold temperature is less, due to the shorter pulse lengths. For example, presuming a threshold temperature of 300C and generating a heat flux of 75 kW/cm2 with the heater element then the donor plate surface reaches that threshold temperature only 4 µs later if a 1 µm thick SiO2 layer is applied. When applying a higher heat flux of 150 kW/cm2, less energy is required to reach the threshold, and the pulse lengths are also shorter. The release time increases from 1 to 3 µs when a 1 µm SiO2 layer is applied.

FIG. 5A to 5I show shows aspects of a first embodiment of the method in more detail.

FIG. 5A shows a cross-section of the donor plate 3 having, at a first side 31 a donor surface 31s. A zone 32 of the donor plate 3 is provided with a heater element 33. In the example shown, the heater element is formed by a resistive heater layer that extends over the full area of the donor plate 3. The resistive heater layer 33 can be locally heated, i.e. within the zone 32 by supplying electric power between first electric contacts 37, 37' , e.g. denoted as anode and an electric contact 38, e.g. denoted as cathode. FIG. 5A further shows an electrically insulating layer 35 on the resistive heater layer 33. In a preparatory step a patterned thermal buffer layer 34 is provided that defines a partitioning of the zone 32 into subzones 32a, 32b, 32c, 32d, in that each subzone has a respective portion of the patterned thermal buffer layer 34. In an embodiment of the method the patterned thermal buffer layer 34 is provided by deposition of a uniform layer of a thermally insulating material, such as a ceramic material, e.g. SiO2 / SiN and then the uniform layer of a thermally insulating material is etched in the desired pattern so as to define the subzones 32a, 32b, 32c, 32d. Deposition is performed for example with a vapor deposition method, e.g. by CVD process, such as PECVD. In an alternative embodiment, the patterned thermal buffer layer 34 is provided in a single step, using a patterning deposition method, e.g. using deposition masks.

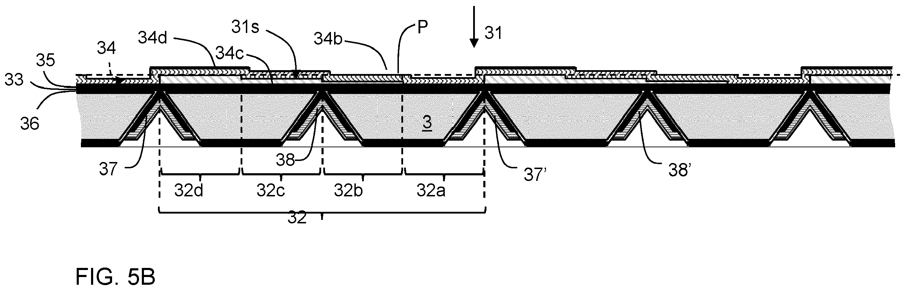

FIG. 5B shows a subsequent step, wherein a layer P of a propulsion agent is deposited, e.g. by slot-die coating or spin coating. In the example shown, the propulsion agent is an adhesive, here a (positive) photoresist.

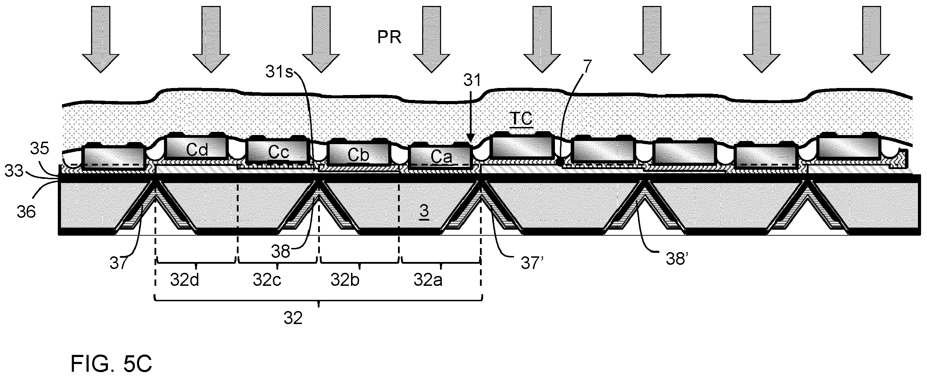

FIG. 5C shows a subsequent step, wherein components Ca, Cb, Cc, Cd, ... are transferred from a temporary carrier TC to the surface 31s cladded with the propulsion agent P. In an example the temporary carrier TC is a UV release tape. In this example, the temporary carrier TC with the components Ca, Cb, Cc, Cd, ... is applied with pressure PR against the layer P of the adhesive propulsion agent on the surface 31s.

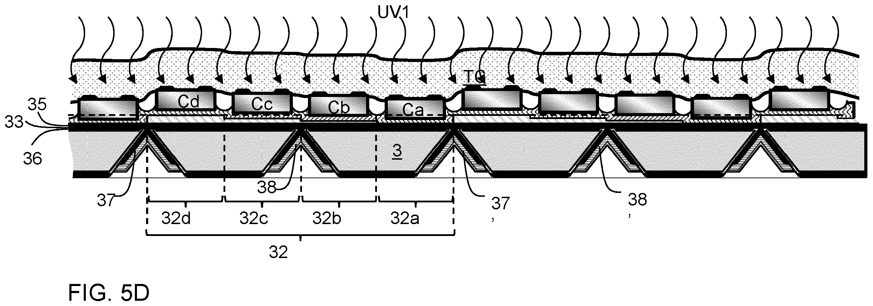

FIG. 5D shows a subsequent step, wherein the temporary carrier TC is irradiated with UV-radiation UV1. Subsequently the temporary carrier TC is removed, leaving the components Ca, Cb, Cc, Cd,... adhered to the surface 31s of the donor plate 3.

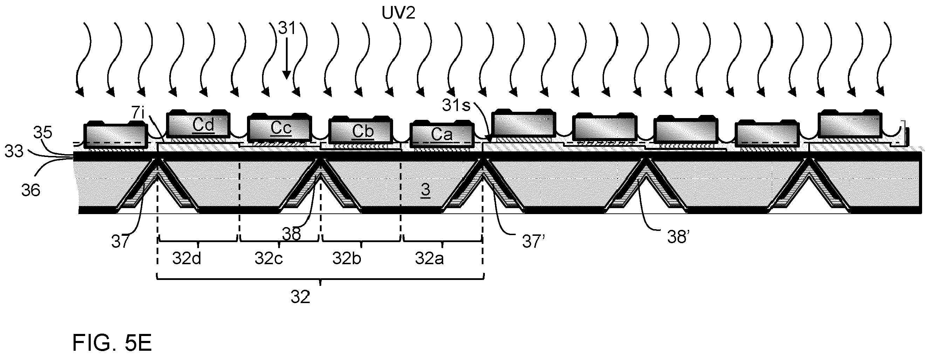

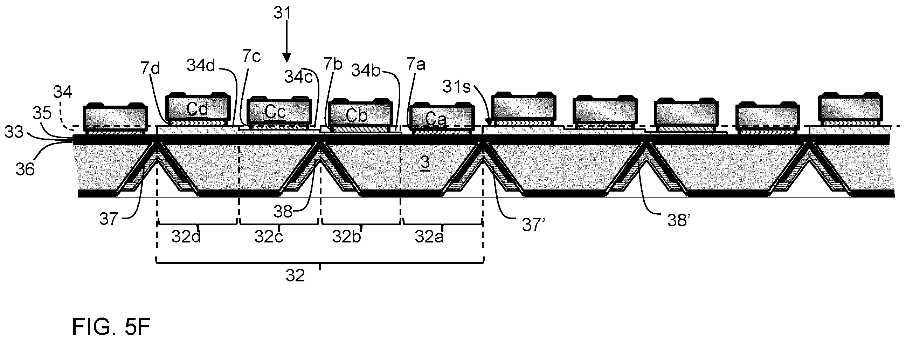

In the subsequent step shown in FIG. 5E, the donor plate 3 having the components Ca, Cb, Cc, Cd,... adhered at its surface 31s is exposed by UV radiation UV2 coming from the first side 31 of the donor plate 3. Therewith portions Pi of the positive photoresist forming the layer P of a propulsion agent that are present between the components Ca, Cb, Cc, Cd,... are developed, and subsequently these portions Pi are removed (See FIG. 5F). Therewith it is avoided that shear forces may occur between mutually neighboring chips.

As shown in FIG. 5F therewith a prepared donor plate 3 is obtained, wherein the Ca, Cb, Cc, Cd,... are adhered to the surface 31s of the patterned thermal buffer layer 34, but are not adhered to each other.

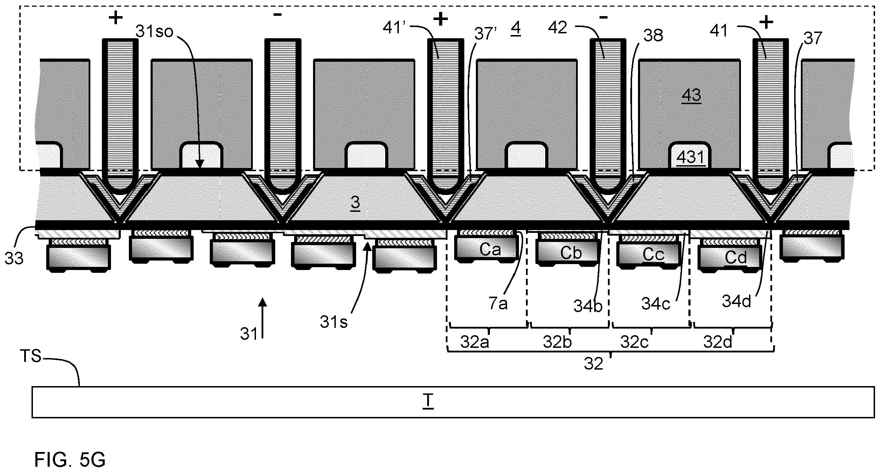

FIG. 5G shows that the donor plate 3 prepared in the preceding steps is arranged by a support unit 4 with its first main side 31 facing a surface TS of a target T. In the example shown the support unit 4 comprises a cooling chuck 43 in thermal contact with a second main surface 31so opposite the main surface 31s of the donor plate. The cooling chuck 43 comprises evacuation channels 431 that are evacuated to clamp the donor plate 3 against the cooling chuck 43 of the support unit by an environmental pressure being relatively high as compared to a pressure in the evacuation channels. In the example shown, the evacuation channels 431 are formed by slits in the surface of the cooling chuck 43 that are covered by the donor plate.

The cooling chuck 43 may be cooled forcedly by cooling channels (not shown) wherein a cooling liquid circulates. Respective contact pins 41, 42, 41', e.g. pogo-pins extend through openings in the cooling chuck 43 and provide for an electrical connection with respective electric contacts 37, 38, 37' of the resistive heater layer 33. Upon evacuating the evacuation channels the donor plate 3 is clamped against the support unit 4 by an environmental pressure being relatively high as compared to a pressure in the evacuation channels. Therewith the electrical connection between the respective contact pins 41, 42, 41' with the respective electric contacts 37, 38, 37' is improved.

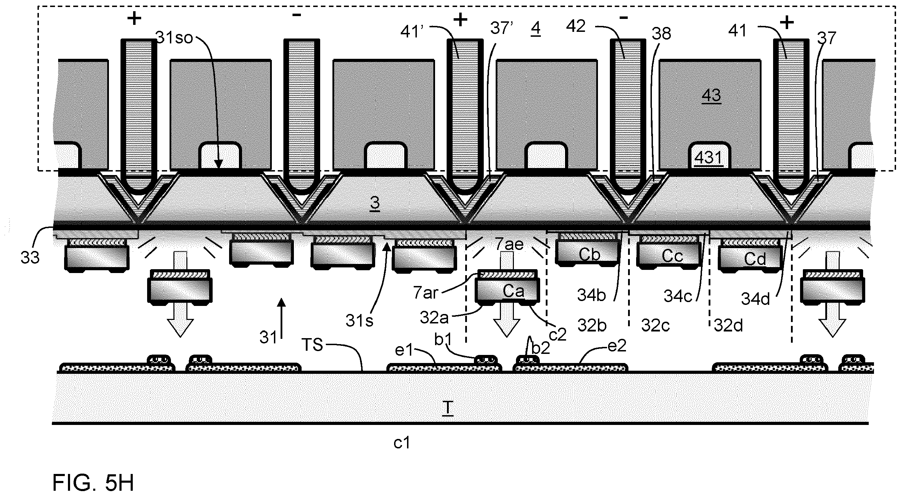

FIG. 5H shows a situation wherein a pulse of electric power is applied to the resistive heater layer in the zone 32. The duration of the pulse is sufficient long to heat the surface 31s in the subzone 32d to above the threshold temperature Tth, however short enough to avoid that the surface 31s reaches the threshold temperature in the subzones 32c, 32b, 32a where a thermal buffer layer portion 34c, 32b, 32a is present. Therewith a portion 7ae of the propulsion agent in the layer 7 below the component Ca evaporates. Due to the fact that the layer 7 is relatively thick, a remainder 7ar of the propulsion agent is ejected with the component Ca towards the surface TS of the target T. The relatively thick layer 7 serves as a thermal insulation to achieve that the components remain relatively cool. In the example shown, the component Ca is transferred to land with electric contacts c1, c2 on respective bond pads b1, b2 which are connected to respective electric conductors e1, e2.

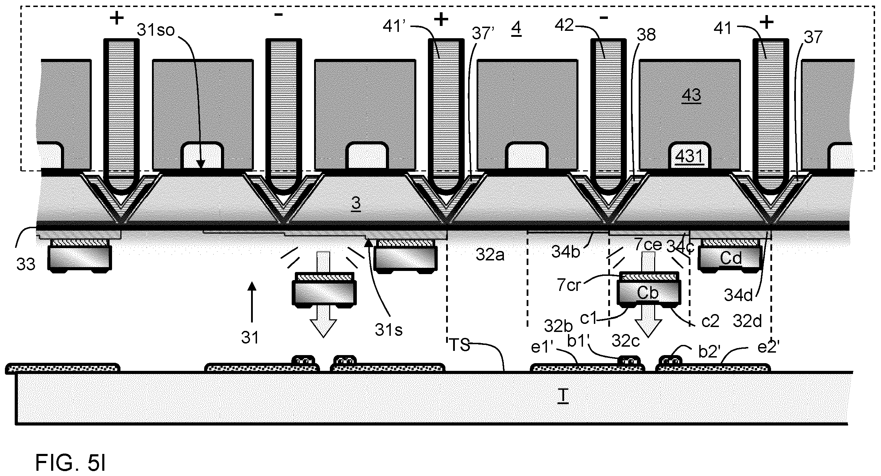

FIG. 5I shows a subsequent situation. In this situation the components Ca and Cb have already been transferred to the target T. Again a pulse of electric power is applied to the resistive heater layer in the zone 32. The duration of the pulse is now sufficient long to heat the surface 31s in the subzone 32c to above the threshold temperature Tth, however short enough to avoid that the surface 31s reaches the threshold temperature in the subzone 32d where a thermal buffer layer portion 34d is present that is thicker than the thermal buffer layer portion 34c. Therewith a portion 7ce of the propulsion agent in the layer 7 below the component Cc evaporates. Due to the fact that the layer 7 is relatively thick, a remainder 7cr of the propulsion agent is ejected with the component Cc towards the surface TS of the target T. The relatively thick layer 7 serves as a thermal insulation to achieve that the components Cc that are being transferred and the components Cd that remain on the donor plate 3 in this stage remain relatively cool. In the example shown, the component Cc is transferred to land with its electric contacts c1, c2 on respective bond pads b1', b2' which are connected to respective electric conductors e1', e2'.

FIG. 6A to 6C show aspects of another embodiment. Therein the adhesive specimen to adhere components in mutually different subzones of the donor surface 31s have mutually different threshold temperatures. In the example shown the adhesive specimen 7b adhering the component Cb in the second subzone 32b has a threshold temperature Tthb higher than the threshold temperature Ttha of the adhesive specimen 7a adhering the component Ca in the first subzone 32a of the donor surface 31s. Further in this example the adhesive specimen 7c in the third subzone 32c has a threshold temperature Tthc higher than the threshold temperature Tthb of the adhesive specimen 7b in the second subzone 32b. And likewise the adhesive specimen 7d in the fourth subzone 32d has a threshold temperature Tthd higher than the threshold temperature Tthc of the adhesive specimen 7c in the third subzone 32c. As noted above, the threshold temperature of an adhesive can be easily modified by adding photo acid generators thereto. Before placing the components on the donor plate, a coating of an adhesive material is exposed with mutually different doses of photo acid generators to control the decomposition temperature per subzone in a zone. Other additives can also be used, but they may be difficult to pattern. Examples of tuning polymer degradation is described by Phillips et al. in "Polymer Degradation and Stability" in Science Direct, Volume 125, March 2016, Pages 129-139.

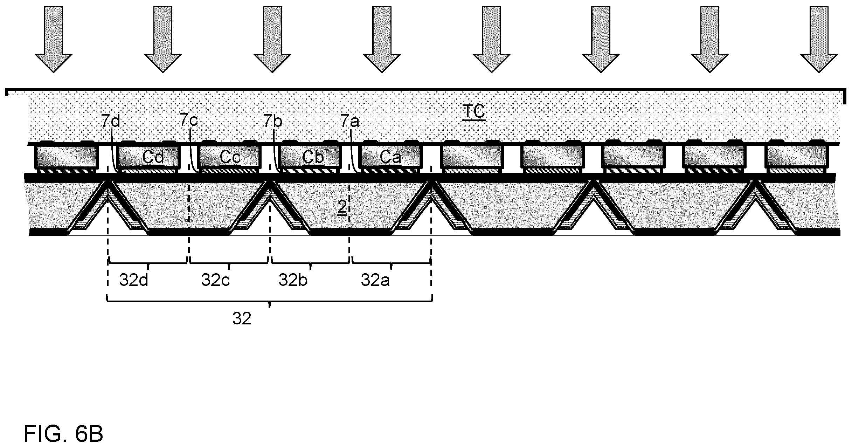

As shown in FIG. 6B, components Ca, Cb, Cc, Cd, .. can be adhered to the adhesive specimen 7a, 7b, 7c, 7d using a temporary carrier TC, in the same way as shown in FIG. 5C for the embodiment using patterned thermal buffer layer. Subsequently, the components can be released from the temporary carrier TC, for example by using UV radiation as illustrated in FIG. 5D.

In one example of this embodiment a thermal buffer layer is absent, or is of uniform thickness.

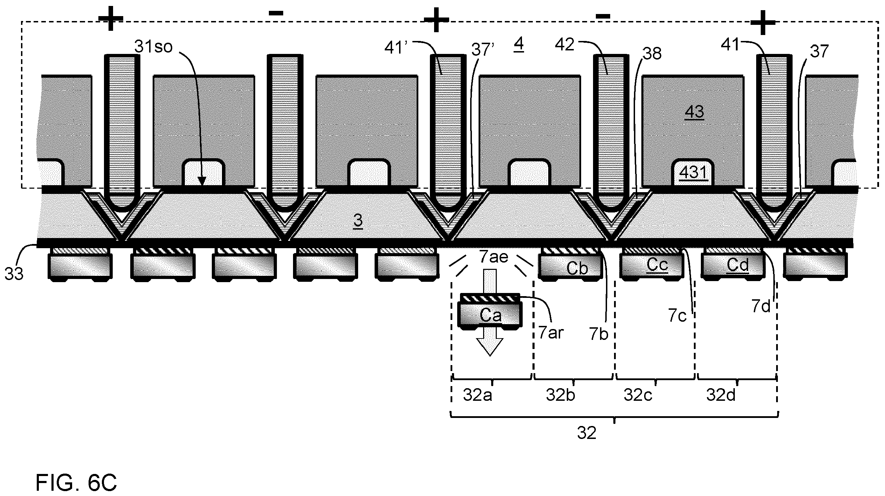

FIG. 6C shows the situation wherein the controller is in its first operational state and causes the power supply 6 to supply a first pulse of electric power to the at least one heater element 33 to heat the donor plate surface 31s in the at least a first subzone 32a to a surface temperature exceeding the threshold temperature Ttha of the adhesive specimen 7a in the first subzone 32a. Therewith at least a portion 7ae of the adhesive specimen 7a is evaporated and the vapor pressure causes the component Ca to be transferred towards the target and be deposited thereon. The heater element 33 heats the entire donor plate surface 31s in the zone 32. However, due to the fact that the adhesive specimen 7b, 7c, 7d have a higher threshold temperature, the components Cb, Cc and Cd remain adhered to the donor plate.

After the controller has caused the target manipulation device 2; 21, 22 to laterally reposition the target T relative to the donor plate, in a second operational state, it assumes the third operational state, wherein it causes the power supply 6 to supply a second pulse of electric power to the at least one heater element 33 to heat the donor plate surface 31s in the second subzone 32b to a surface temperature exceeding the threshold temperature Tthb of the adhesive specimen 7b in the second subzone 32b. Consequently the second component Cb is transferred. Likewise the third component Cc and the fourth component Cd can be transferred by subsequently providing a third pulse and a fourth pulse of electric power to the heater element 33. If desired the controller causes the target manipulation device 2; 21, 22 to laterally reposition the target T relative to the donor plate between the second pulse and/or between the third and the fourth pulse.

Additionally, between mutually subsequent pulses of power a forced cooling of the zone 32 can be achieved by cooling the donor plate by a cooling chuck 43 in thermal contact with the donor plate 3. In one example the cooling chuck 43 is in permanent contact with the donor plate 3 during operation and when a pulse of electric power is supplied to heater element, the heatflux provided by the heater element to the donor plate surface 31s exceeds that of the heat flux towards the cooling chuck. This embodiment is advantageous in that it has a minimum of moving parts and can be controlled relatively easily. Also operation can take place at a high speed, because cooling down occurs immediately upon the end of a pulse. In another embodiment the controller controls an actuator that brings the cooling chuck in thermal contact with the donor plate upon finishing a pulse and interrupts the thermal contact upon the onset of a pulse. This embodiment is attractive if a high operational speed is not necessary because heating an take place with a lower amount of energy.

In another example the specimen of mutually different threshold temperature are used in combination with the embodiment wherein the donor plate comprises thermal buffer layers of mutually different thicknesses in respective subzones.

FIG. 7A - 7D show a still further embodiment, wherein the donor plate 3 is provided with spacer pillars 39a - 39d to support the components at mutually different distances from the heater element 33. In the embodiment shown the heater element 33 is a resistive heater layer. In another embodiment the heater element is a photon radiation absorbing layer that is heated by directing photon radiation thereto.

As shown in FIG. 7A the subzone 32a has spacer pillars 39a that are to support a component relatively close to the heater element. The subzones 32b, 32c and 32d has subsequently longer spacer pillars 39b, 39c and 39d to support a component further away from the heater element 33.. The pillar height controls a heat sinking effect into a component present thereon. The lower the pillar height, the stronger the heat sinking effect. Therewith it is achieved that upon heating a zone, the temperature of the surface in a subzone between the lower pillars remains below a temperature of a subzone between the higher pillars. This renders it possible to exceed a single predetermined threshold temperature in successive subzones having successively higher pillars by generating heating pulses with successively increasing duration and/or power.

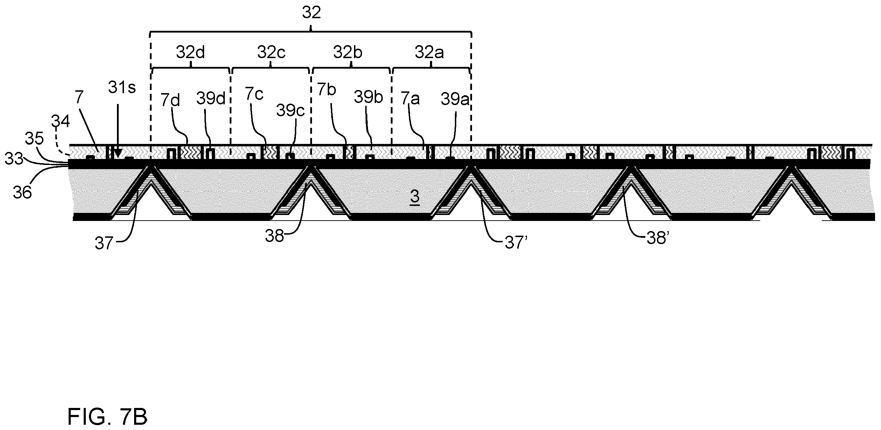

FIG. 7B shows that an adhesive layer 7 is uniformly deposited over the surface of the donor plate 3 provided with the spacer pillars 39a - 39d. This can most easily be performed by spin coating.

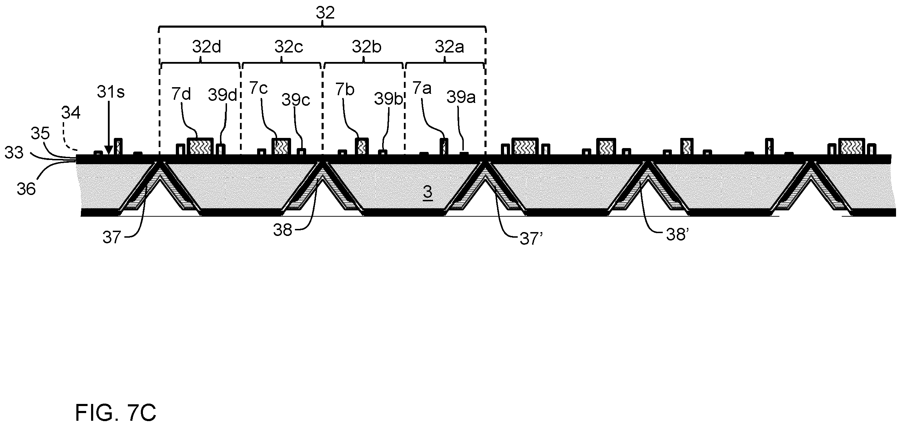

In case the adhesive layer is provided as a positive photo-resist the layer 7 is selectively irradiated outside the areas between the pillars where adhesive specimen 7a, 7b, 7c, 7d are to be formed for adhering the components. A shown in FIG. 7C, subsequent to irradiation, the excess photoresist which is irradiated can be removed so that only the partially cured portions 7a, 7b, 7c, 7d remain between respective pillars.

Optionally, the adhesive used is a photoresist comprising a photoacid generator. The threshold temperature of portions 7a, 7b, 7c, 7d of the adhesive in mutually different subzones can be modified to a different value by activating the photoacid generator to a mutually different extent as determined by a duration or intensity of irradiation with photo radiation (e.g. UV-radiation).

Due to the fact that the adhesive portions 7a, 7b, 7c, 7d have been partially cured by photon radiation with mutually different intensity and/or duration they have a mutually different threshold temperature. The threshold temperature increases in the order of 7a, 7b, 7c, 7d.

The spacer pillars 39a - 39d control the adhesive thickness between the chip and the heater. Controlling the heat sinking effect into the component will help to create thermal contrast. Especially because the adhesive is polymer based and has a low thermal conductivity (∼0.2 W/mK), minor thickness differences will have a significant effect on the temperature buildup at the heater/adhesive interface. As an example, the spacer pillars 39a - 39d may have a height selected from a range between 50 nm and 50 µm.

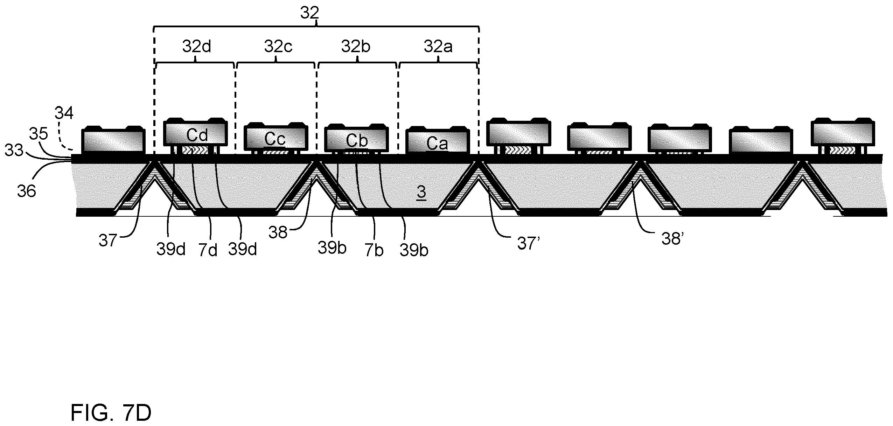

As shown in FIG. 7D, upon pressing the components Ca, Cb,... against the spacer pillars 39a - 39d, the components are adhered to the adhesive portions 7a, 7b, 7c, 7d and the adhesive laterally distributes on the donor plate surface between the spacer pillars 39a - 39d. It is avoided that the adhesive portions 7a, 7b, 7c, 7d contact the pillars by partially curing a volume of the adhesive that is less than a volume enclosed by the pillars. Therewith it is avoided that shear forces occur due to adhesive adhered to the pillars when the component is transferred.

FIG. 8A and 8B shows a plate of an embodiment of the deposition device according wherein a zone 32 comprises a plurality of subzones 32a, 32a',...; 32b, 32b' ...; 32c, 32c'; 32d, 32d') having a condition that the surface temperature exceeds the threshold temperature of the adhesive specimen therein upon supply of a same pulse of power.

FIG. 8A is a top-view of a single zone 32 of the donor plate 3 that is partitioned into 5x5 sections. The 25 sections each have their thermal buffer layer patterned in the same way. For example, as shown in FIG. 8B, which shows a cross-section through five sections B1 - B5 of the plate 3 according to B-B in FIG. 8A, the sections have a first subzone 32a, 32a', ... wherein the thickness of the buffer layer 34 is 0, a second subzone 32b, 32b', ... wherein the buffer layer 34 has a first thickness, different from 0, a third subzone 32c, 32c', ... wherein the buffer layer 34 has a second thickness, different from 0 and different from the first thickness, etc.

As shown in FIG. 8C, upon supplying the first power pulse to the heater element 33 of the zone 32, all components Ca, Ca', Ca", Ca‴, Caʺʺ in the first subzone of the subsections are transferred to the target surface TS of the target T. However the remaining components remain adhered to the plate 3. When the next power pulse, having a longer duration or magnitude, a next group of components is transferred from the second subzones 32b, 32b' (See FIG. 8B), ... wherein the buffer layer 34 has a first thickness, etc.

As shown in FIG. 9, the component to be transferred to the target surface TS of the target T may also be a substance for providing interconnections on the target surface or contrary thereto for providing a thermal and/or electrical insulation. In the example shown in FIG. 9, the substance is a solder for forming a bond pad b on the surface. In the example shown, the plate 3 comprises a plurality of zones 32, 32'..., that each have a respective heater element 33, 33'. Each zone is partitioned into sub-zones 32a, 32b, 32c, 32d. These sub-zones are distinct from each other by a thickness of a thermal buffer layer therein. In the sub-zones 32a the thickness of the thermal buffer layer is 0. The adhesive specimen 7a, 7b, 7c, 7d in these subzones is formed of the material of the component to be deposited. In this example the material is a solder paste. As an example, the solder paste has a composition as follows:

| | | | |
|---|---|---|---|
| Solids content | 85±5 wt% | | |
| Material | | Solids content | Purpose |
| Metal Alloy (SAC305): | 85±5 wt% | | Conductivity |
| Flux | 10±5% wt% | Oxide removal | |
| Other | 5±5wt% | Printability | |

The solder paste in this example has a viscosity in the range of 100 en 1000 Pa*s. In contrast to conventional screen print paste and inks shear thinning may be minimized e.g. by adding fumed silica to prevent flow of the past on the acceptor substrate. This can also be prevented by curing/drying the ink e.g..by laser irradiation, which can be conveniently realized by a high solids content and low solvent content.

In the example of FIG. 9 a first pulse is provided to heat the zone 32. In a subzone 32a thereof a thermal buffer layer has zero-thickness. Therewith the temperature of the surface 31s in the subzone 32a exceeds the threshold temperature of the solder in the subzone 32a, i.e. the temperature at which a portion (7ae) of the solder paste in contact with the surface 31a evaporates and causes a transfer of the remainder (7ar) of the solder paste in the subzone to be transferred to the target surface where it forms a bond pad b. Subsequent to a relative lateral displacement of the plate 3 and the target relative to each other a next power pulse is supplied to heat the zone 32, having a longer duration or magnitude. Therewith the temperature of the surface 31s in the subzone 32b exceeds the threshold temperature of the solder paste therein causing of a transfer of the main portion thereof in molten form to the target surface where it forms a bond pad, and so on.

As noted the same principle is applicable to other substances to be deposited for forming an electric or a thermal contact, or for providing a thermal or electrical insulation. Also deposition may take place collectively for a group of electrically or thermally conducting or insulating components as described with reference to FIG. 8A - 8C. Also it is possible to tune the threshold temperature of the material of the component for example by selectively activating a photoacid generator comprised therein.

In the claims the word "comprising" does not exclude other elements or steps, and the indefinite article "a" or "an" does not exclude a plurality. A single component or other unit may fulfill the functions of several items recited in the claims. The mere fact that certain measures are recited in mutually different claims does not indicate that a combination of these measures cannot be used to advantage. Any reference signs in the claims should not be construed as limiting the scope.

## Claims

1. A deposition device (1) for depositing components (Ca, Cb,..) on a target surface (TS) of a target (T), the deposition device comprising:
a donor plate (3) and at least one heater element (33) to heat a donor plate surface (31s) in at least one zone (32), the donor plate surface (31s) being configured for temporarily adhering thereto respective components with a respective adhesive specimen (7a, 7b,...) in respective subzones (32a, 32b,...) of the at least one zone (32) wherein an adhesive specimen adhering a component in a respective subzone evaporates if a temperature of the donor surface in the respective subzone exceeds a threshold temperature of said adhesive specimen;
a power supply (6) configured for controllably supplying a pulse of electric power to the at least one heater element to heat the donor plate surface (31s) in the at least one zone (32),
a target manipulation device (2; 21, 22) for laterally positioning the target (T) relative to the donor plate (3), while holding the target (T) with its target surface (TS) facing the donor plate surface (31s),
a controller (5) configured for controlling the power supply (6) and the target manipulation device (2;21, 22), which controller in a first operational state causes the power supply (6) to supply at least a first pulse (Pulse 1) of electric power to the at least one heater element (33) to heat the donor plate surface (31s) in the at least a first subzone (32a) to a surface temperature exceeding a threshold temperature of the adhesive specimen (7a) in said first subzone (32a), which in a second operational state causes the target manipulation device (2) to change a lateral position of the target (T) relative to the donor plate (3), which in a third operational state causes the power supply (6) to supply at least a second pulse (Pulse 2) of electric power to the at least one heater element to heat the donor plate surface (31s) in the at least a second subzone (32b) to a surface temperature exceeding a threshold temperature of the adhesive specimen (7b) in said second subzone (32b).

2. The deposition device (1) according to claim 1, wherein the donor plate comprises in the at least one second subzone (32b) a thermal buffer layer (34b) between the at least one heater element (33) and the donor plate surface (31s).

3. The deposition device (1) according to claim 2, wherein the thermal buffer is of a ceramic material and has a thickness of at most 2 µm.

4. The deposition device (1) according to claim 1, 2 or 3, wherein the adhesive specimen (7b) adhering the component (Cb) in the second subzone (32b) of the donor surface (31s) has a threshold temperature (Tthb) higher than that of the adhesive specimen (7a) adhering the component (Ca) in the first subzone (32a) of the donor surface (31s).

5. The deposition device (1) according to any of the preceding claims, comprising a support unit (4) for supporting the donor plate (3) during operation.

6. The deposition device (1) according to claim 5, comprising a cooling chuck (43) in thermal contact with the donor plate (3) in order to cool down the donor plate (3) between mutually subsequent pulses.

7. The deposition device (1) according to claim 6, wherein the cooling chuck (43) comprises a cooling channel for conducting a cooling liquid therethrough.

8. The deposition device according to claim 5, 6 or 7, wherein the support unit (4) comprises vacuum channels that are evacuated to clamp the donor plate (3) against the support unit (4) by an environmental pressure being relatively high as compared to a pressure in the evacuation channels.

9. The deposition device according to claim 5, 6, 7 or 8 wherein the support unit (4) comprises respective contact pins (41, 42, 41') to provide for an electrical connection with respective electric contacts (37, 38, 37') of the resistive heater layer (33).

10. The deposition device according to any of the preceding claims wherein the donor plate surface (31s) of the donor plate (3) is provided with spacer pillars (39a - 39d) to support the components at mutually different distances from the heater element (33).

11. The deposition device according to one of the preceding claims, wherein the zone (32) comprises a plurality of subzones (32a, 32a',...; 32b, 32b' ...; 32c, 32c'; 32d, 32d') having a condition that the surface temperature exceeds the threshold temperature of the adhesive specimen therein upon supply of a same pulse of power.

12. A method for depositing components (Ca, Cb, ..) on a target surface (TS) of a target (T), the method comprising:
providing a donor plate (3) with at least one heater element (33) to heat a donor plate surface (31s) of the donor plate (3) in at least one zone (32) of the donor plate,
adhering respective components (Ca, Cb,...) with respective adhesive specimen (7a, 7b,...) to the donor surface (31s) in respective subzones (32a, 32b) of the at least one zone (32) wherein an adhesive specimen adhering a component in a respective subzone evaporates if a temperature of the donor plate surface in the respective subzone exceeds a threshold temperature of said adhesive specimen;
positioning the target (T) with its target surface (TS) facing the donor plate surface (31s) of the donor plate (3),
supplying at least a first pulse of electric power to the at least one heater element (33) to heat the donor surface (31s) wherein a temperature of the donor plate surface in at least a first one (32a) of the subzones assumes a value that is at least the threshold temperature of the adhesive species (4a) adhering a first component (Ca) in said first one of the subzones to eject the first component and wherein a temperature of the donor surface in at least a second one (32b) of the subzones assumes a value that does not exceed the threshold temperature of the adhesive specimen (7b) adhering the component (Cb) in said second one of the subzones;
laterally translating the target (T) relative to the donor plate (3);
supplying at least a second pulse of electric power to the at least one heater element (33) to heat the donor surface (31s), wherein a temperature of the donor surface in the second one (32b) of the subzones assumes a value that is at least the threshold temperature of the adhesive specimen (7b) adhering the component (Cb) in said second one (32b) of the subzones therewith ejecting the component (Cb) in the second subzone (32b) towards the target (T).

13. The method according to claim 12, comprising providing the donor plate (3) in the at least one second subzone (32b) with a thermal buffer layer (34b) between the at least one heater element (33) and the donor plate surface (31s).

14. The method according to claim 12 or 13, comprising adhering the component (Cb) in the second subzone (32b) of the donor surface (31s) with an adhesive specimen (7b) that has a threshold temperature (Tthb) higher than that of the adhesive specimen (4a) adhering the component (Ca) in the first subzone (32a) of the donor surface (31s).

15. The method according to claim 14 comprising providing for adhesive specimen with mutually different threshold temperatures by depositing a precursor of said specimen comprising a photo acid generator (PAG) and partially curing the precursor in mutually different subzones with mutually different curing conditions.

16. The method according to claim 12, 13 or 14, wherein in the step of adhering (S2) the adhesive specimen is provided with thickness in a range of 0.1 µm to 10 µm.

17. The method according to any of the claims 12 - 16, wherein adhering respective components (Ca, Cb,...) comprises:
pressing a temporary carrier (TC) with said components adhered thereto against the donor plate surface (31s) provided with an adhesive material;
removing the temporary carrier TC to leave the components (Ca, Cb, ... ) adhered to the adhesive on surface (31s) of the donor plate (3).

18. The method according to claim 17, wherein the temporary carrier (TC) is a photo-sensitive-release tape or thermal release tape, and wherein an adhesion of the components (Ca, Cb, ... ) to the photo-sensitive-release tape is reduced by irradiating the photo-sensitive-release tape with photon radiation or by heating the thermal release tape.

19. The method according to any of the claims 12-18, wherein the adhesive material provided on the surface (31s) of donor plate (3) is a positive photoresist and wherein subsequent to adhering the respective components (Ca, Cb,...) UV-radiation is directed to a side (31) of the donor plate (3) having the components (Ca, Cb, ...) adhered at its surface (31s) to expose portions of the positive resist present between said components to said UV-radiation, and wherein subsequently the exposed portions of the positive resist are removed.

20. The method according to any of the claims 12-19, comprising:
providing the donor plate surface (31s) in mutually different subzones (32a, 32b, 32c, 32d) with spacer pillars (39a, 39b, 39c, 39d) of mutually different height;
providing adhesive specimen (7a, 7b, 7c, 7d) between the pillars in the subzones at a height exceeding that of said pillars;
pressing respective components against the pillars in respective zones, therewith bringing the component in contact with the adhesive specimen to adhere the components to the donor plate surface (31s).

21. The method according to claim 20, wherein the spacer pillars are of an electrically conductive material, wherein the step of pressing respective components against the pillars comprises electrically connecting respective electric contacts of the component with respective pillars to a testing unit for testing the component.

22. The method according to claim 20 or 21, wherein providing adhesive specimen comprises:
uniformly depositing a photoresist as the precursor on the donor plate surface (31s) with the spacer pillars (39a, 39b, 39c, 39d) to a height exceeding a height of the highest spacer pillars;
selectively exposing the layer of photoresist to photon radiation therewith leaving unexposed a respective volume of the photoresist between the pillars in each subzone, wherein said respective volume is less than a volume defined between the pillars in each subzone, therewith curing photoresist of the layer not being present in said volumes;
removing the irradiated photoresist.

23. The method of claim 22, wherein the photoresist comprises a photoacid generator and wherein, subsequent to the step of removing the cured photoresist respective volumes in a zone are partially activated to a mutually different extent by irradiation with photon radiation with mutually different intensities or duration to achieve that the respective volumes of photoresist in said zones have a mutually different threshold temperature.

24. A donor plate (3) for use in the deposition device (1) comprising:
at least one heater element (33) to heat a donor plate surface (31s) in at least one zone (32), the donor plate surface (31s) being configured for temporarily adhering thereto respective components with a respective adhesive specimen (7a, 7b,...) in respective subzones (32a, 32b,...) of the at least one zone (32) wherein an adhesive specimen adhering a component in a respective subzone evaporates if a temperature of the donor surface in the respective subzone exceeds a threshold temperature of said adhesive specimen;
wherein the donor plate comprises in the at least one second subzone (32b) a thermal buffer layer (34b) between the at least one heater element (33) and the donor plate surface (31s).
